# EUROPEAN PATENT APPLICATION

(11) **EP 4 657 900 A1**
(43) Date of publication of application: **03.12.2025**
(21) Application number: 25172530.5
(22) Date of filing: 25.04.2025
(51) Int. Cl.: H04W 4/021, H04W 4/029, G06N 7/06, G08G 1/01

(54) **MEASURE EXECUTION PROGRAM, MEASURE EXECUTION METHOD, AND INFORMATION PROCESSING DEVICE**

(30) Priority: 27.05.2024 JP 2024085701
(71) Applicant: FUJITSU LIMITED, Kawasaki-shi, Kanagawa 211-8588 (JP)
(72) Inventor: IGARASHI, Shinsa, Kawasaki-shi, Kanagawa, 211-8588 (JP); SEGAWA, Eigo, Kawasaki-shi, Kanagawa, 211-8588 (JP)
(74) Representative: Hoffmann Eitle

(57) **Abstract**

An information processing device (10) generates a digital twin that reproduces the real world in a virtual space and acquires information regarding a person present in a predetermined area of the real world. The information processing device (10) performs a simulation of the movement of the person in the generated digital twin using the acquired information regarding the person. The information processing device (10) generates information indicating a result of verification of a measure to be applied to the predetermined area based on the result of the performed simulation, and outputs the generated information indicating the verification result to a display screen.

## Description

### FIELD

Embodiments discussed herein are related to measure execution programs, measure execution methods, and information processing devices.

### BACKGROUND

The verification of measures or policies is conducted in various situations, and such measure verification is performed using a simulation to estimate the effectiveness and impacts of the measure.

Patent Literature 1: Japanese Unexamined Patent Publication No. 2023-182560

However, conventional techniques perform simulations using preset calculation formulas or the like, so it is possible to obtain solely simulation outcomes under specific conditions, which makes it challenging to assert that it is possible to perform simulations that accurately reflect the real world. Furthermore, it is challenging to assert that measures developed based on such simulation results achieve a high level of effectiveness upon implementation in the real world.

Accordingly, it is an object in one aspect of an embodiment of the present invention to provide a measure execution program, a measure execution method, and an information processing device capable of improving the accuracy of measure verification.

### SUMMARY

According to an aspect of an embodiment, a measure execution program that causes a computer (10) to execute a process including generating (S201) a digital twin reproducing a real world in a virtual space; acquiring (S202, S203) information regarding a person present in a predetermined area of the real world, performing (S204, S205), in the generated digital twin, a simulation concerning movement of the person using the acquired information regarding the person, generating (S206) information indicating a verification result of a measure to be applied to the predetermined area based on a result of the performed simulation, and outputting (S207) the generated information indicating the verification result to a display screen.

### BRIEF DESCRIPTION OF THE DRAWINGS

FIG. 1 is a diagram illustrated to describe measure execution by an information processing device according to a first embodiment;
FIG. 2 is a diagram illustrated to describe an example of generating destination data;
FIG. 3 is a diagram illustrated to describe an example of deterioration in the accuracy of destination data;
FIG. 4 is a functional block diagram illustrating the functional configuration of the information processing device according to the first embodiment;
FIG. 5 is a diagram illustrated to describe an example of generating a movement purpose data;
FIG. 6 is a diagram illustrated to describe an example of generating destination data;
FIG. 7 is a diagram illustrated to describe an example of adding destination data;
FIG. 8 is a diagram illustrated to describe an example of generating an attribute;
FIG. 9 is a diagram illustrated to describe an example of generating attribute-added movement data;
FIG. 10 is a diagram illustrated to describe an example of analyzing a measure;
FIG. 11 is a diagram illustrated to describe an example of displaying the effectiveness of a measure;
FIG. 12 is a flowchart illustrating the processing procedure;
FIG. 13 is a flowchart illustrating the processing of simulation using a behavior selection model; and
FIG. 14 is a diagram illustrated to describe an exemplary hardware configuration.

### DESCRIPTION OF EMBODIMENTS

Preferred embodiments will be explained with reference to accompanying drawings. Moreover, the present invention is not limited to these embodiments. The embodiments can be appropriately combined with each other as long as there is no inconsistency.

### (a) First Embodiment

### Description of Measure Execution System

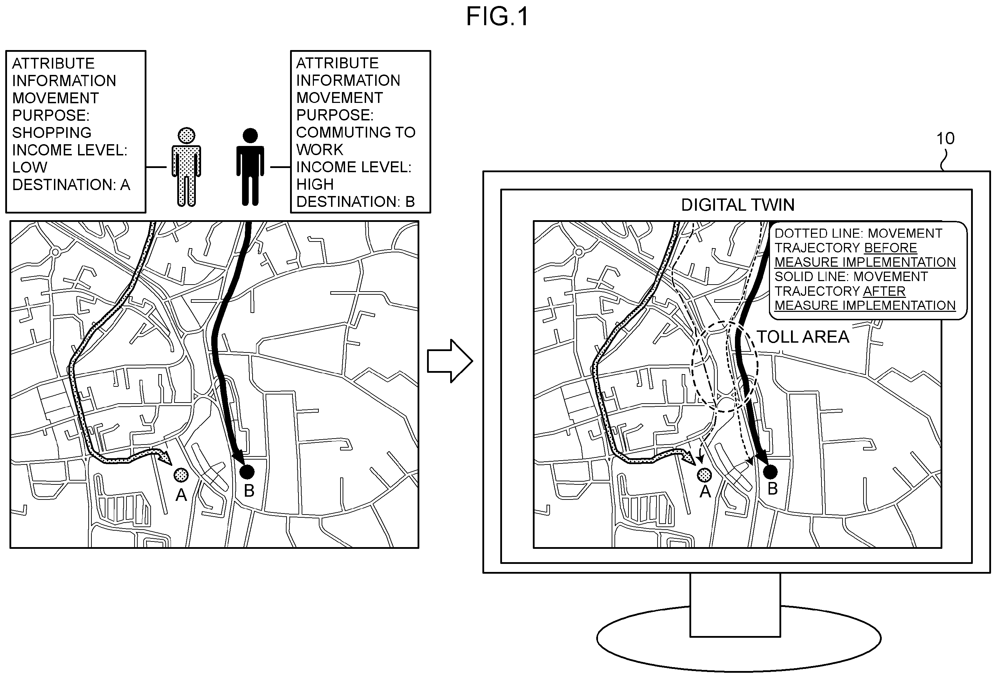

FIG. 1 is a diagram illustrated to describe measure execution performed by an information processing device 10 according to a first embodiment. The information processing device 10 illustrated in FIG. 1 executes a simulation on a digital twin as an initiative to digitally reproduce individual behavior, search for a measure or policy intended to solve social issues, and verify the measure. The information processing device 10 uses, as input, person's movement data (movement trajectory data) with attribute information, such as age, income, destination, and mode of transportation, and verifies the effectiveness of the measure based on the person's reactions to the measure in the digital twin.

Specifically, the information processing device 10 generates a digital twin that reproduces the real world in a virtual space and acquires information regarding a person present in a predetermined area of the real world. Then, in the generated digital twin, the information processing device 10 performs a simulation concerning the movement of the person using the acquired information regarding the person. Subsequently, the information processing device 10 generates information indicating a verification result of the measure to be applied to a predetermined area based on a result obtained from the performed simulation and outputs the generated information indicating the verification result to a display screen.

For example, the information processing device 10 acquires, as data regarding a person residing in a specific region, movement data of person A having attribute information of "movement purpose: shopping, income level: low, destination: A" and movement data of person B having attribute information of "movement purpose: commuting to work, income level: high, destination: B". Then, if there are measures such as "a change in congestion and traffic volume in the case where a toll area for charging a toll is established in a partial area in a specific region to alleviate traffic congestion in the specific region", the information processing device 10 verifies, using the digital twin, how the movement trajectories of person A and person B change. In this regard, the movement trajectory of a person includes not only walking but also automobiles, taxis, buses, or the like. For example, in the example of FIG. 1, before and after establishing the toll area, there is no change in the movement route of person B who has a high income, whereas there is a change in the movement route of person A who has a low income. In other words, the simulation upon the execution of the measure of establishing the toll area makes it possible to be expected to obtain the effectiveness that congestion in a predetermined area is reduced.

In this way, the information processing device 10 is capable of constructing a digital twin using real-world environmental data and executing and verifying various measures on the digital twin, thereby improving the accuracy of measure verification.

By the way, since it is difficult to obtain movement data with attribute information in terms of personal information protection based on easily available person's movement data (without attribute information), statistical data, or the like, movement data with attribute information is currently being created.

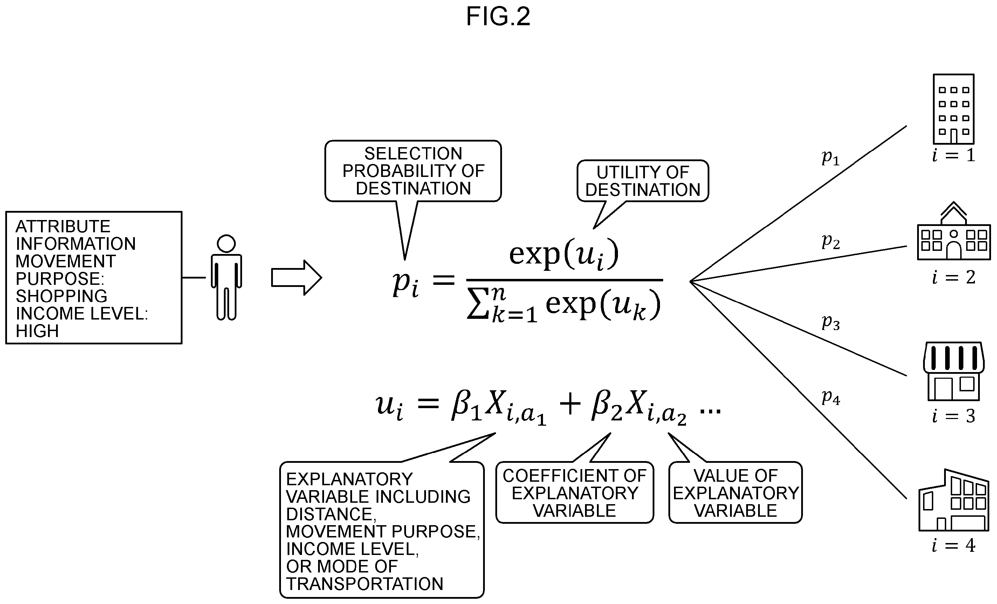

In one example, a description is given regarding destination data to which a destination, one piece of the attribute information, is assigned. FIG. 2 is a diagram illustrated to describe an example of generating destination data. As illustrated in FIG. 2, the destination data is generated by calculating the selection probability for each destination candidate using a multinomial logit model with an explanatory variable such as the movement purpose, income level, distance from home to the destination candidate, and number of employees. For example, the utility "u" of a destination is calculated using "i" indicating the destination, the coefficient β of the explanatory variable, and each explanatory variable X such as distance, movement purpose, income level, and mode of transportation, and the selection probability "pᵢ" of each destination is calculated using the utility "u" of the destination. Then, "pᵢ" with the highest selection probability or "pᵢ" closest to the random variable is selected as the destination. Moreover, examples of destinations include a company with "i = 1", a school with "i = 1", a store with "i = 3", a hospital with "i = 4", and the like.

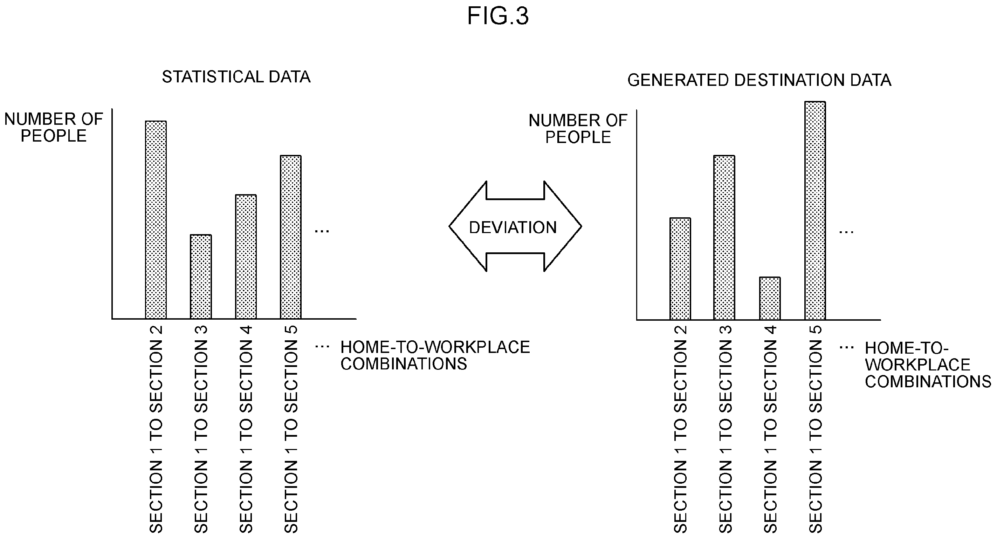

However, compared to the movement purpose such as shopping or hospital visits, destination data regarding commuting to work or attending school sometimes deviates from the true value (statistical data). FIG. 3 is a diagram illustrated to describe an example of the deterioration in the accuracy of destination data. FIG. 3 illustrates the number of people who fall into the combination of section 1 where the home is located and sections (sections 2 to 5) where the workplace is located, and it represents the number of people who fall into the combination of the home (section 1) and workplaces (section 2, section 3, section 4, or section 5) in the statistical data from the census or the like, and the number of people who fall into the combination of section 1 and sections (section 2, section 3, section 4, or section 5) in the destination data generated by the technique in FIG. 2.

As can be seen from FIG. 3, in the statistical data, the order of the number of people is "the number of people heading from section 1 to section 2", "the number of people heading from section 1 to section 5", "the number of people heading from section 1 to section 4", and "the number of people heading from section 1 to section 3", in the descending order, while in the destination data, the order of the number of people is "the number of people heading from section 1 to section 5", "the number of people heading from section 1 to section 3", "the number of people heading from section 1 to section 2", and "the number of people heading from section 1 to section 4", in the descending order, so there is a discrepancy between both datasets.

This deviation is likely because, in the case where the movement purpose is commuting to work or attending school, the destination is not necessarily determined solely based on factors such as distance or income level. The use of such destination data to verify a measure in the digital twin decreases the verification accuracy, which also results in the deterioration of the verification accuracy of the measure.

Thus, the information processing device 10 according to the first embodiment uses different techniques for generating the destination data depending on the movement purpose. For example, in the case where the movement purpose is commuting to work or attending school, the information processing device 10 generates the destination data using the selection probability calculated from the statistical data, and in the case where the movement purpose is other purposes than that described above, such as shopping or hospital visits, the information processing device 10 generates the destination data using the selection probability calculated from the attribute information.

As a result, even if the number of pieces of destination data is small upon evaluating a measure in the digital twin, the information processing device 10 is capable of generating the destination data that does not deviate from the statistical data, thereby reducing or preventing the deterioration in the verification accuracy of the measure.

### Functional Configuration

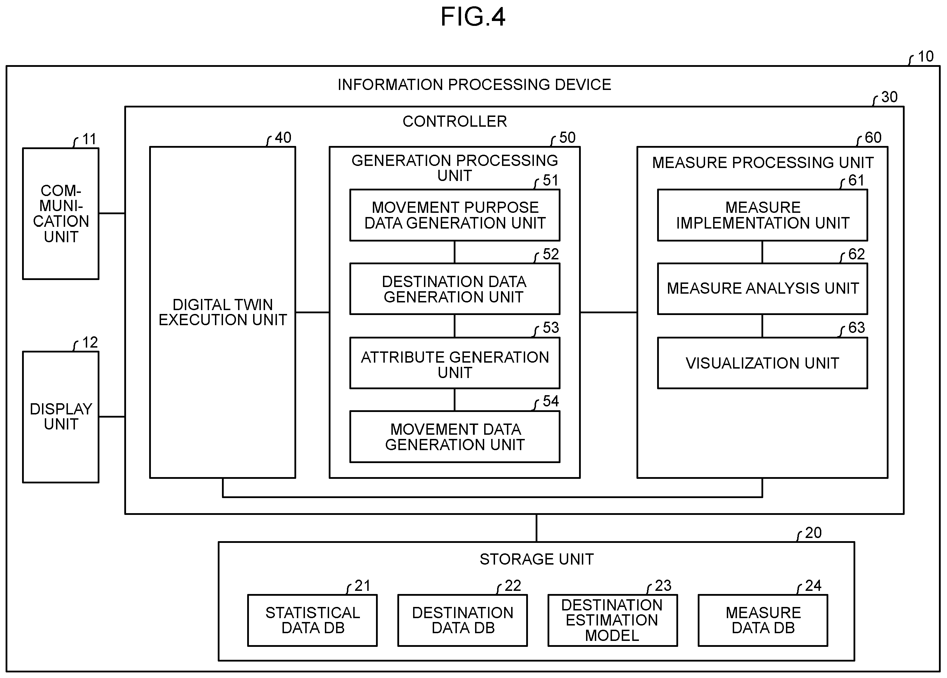

FIG. 4 is a functional block diagram illustrating the functional configuration of the information processing device 10 according to the first embodiment. As illustrated in FIG. 4, the information processing device 10 is an exemplary computer that includes a communication unit 11, a display unit 12, a storage unit 20, and a controller 30.

The communication unit 11 is a processing unit that controls communication with other devices and is implemented using, for example, a communication interface or the like. For example, the communication unit 11 receives information regarding the verification target measure, statistical data, or the like from an administrative terminal used by an administrator, and transmits a verification result, simulation result, or the like to the administrative terminal.

The display unit 12 is a processing unit that outputs various types of information for display and is implemented using, for example, a display, a touch panel, or the like. For example, the display unit 12 outputs a verification result, simulation result, or the like for display.

The storage unit 20 is a processing unit that stores various data or programs or the like executed by the controller 30, and is implemented using, for example, memory, a hard disk, or the like. The storage unit 20 stores a statistical data DB 21, a destination data DB 22, a destination estimation model 23, and a measure data DB 24.

The statistical data DB 21 is a database that stores statistical data collected and published through a census survey or the like conducted by prefectures or municipalities. For example, the statistical data DB 21 stores inter-section destination data indicating the number of people moving from a specific section to a destination section, income data indicating the income of a user belonging to each section, and worker data indicating the number of workers in each section.

The destination data DB 22 is a database that stores destination data among the statistical data. For example, the destination data DB 22 stores, for each region, data regarding the number of people who move from section 1 to each section (section 2, section 3, section 4, or section 5) as the destination in a specific region.

The destination estimation model 23 is a model used to estimate the destination in the case of a purpose other than commuting to work or attending school. For example, the destination estimation model 23 is the mathematical formula illustrated in FIG. 2.

The measure data DB 24 is a database that stores data regarding a verification target measure. For example, the measure data DB 24 stores a measure, such as the implementation of a toll area on a given road in a specific region or the integration of hospitals in a specific region.

The controller 30 is a processing unit that manages the entire information processing device 10 and is implemented using, for example, a processor or the like. The controller 30 has a digital twin execution unit 40, a generation processing unit 50, and a measure processing unit 60. Moreover, the digital twin execution unit 40, the generation processing unit 50, and the measure processing unit 60 are implemented using, for example, electronic circuits included in a processor, processes executed by the processor, or the like.

The digital twin execution unit 40 is a processing unit that generates a digital twin that reproduces the real world in a virtual space. Specifically, in the case of generating a digital twin for a specific region, the digital twin execution unit 40 generates a digital twin that virtually reproduces the region using real-world environmental data such as road information, traffic information, weather information, and personal information regarding the region. In addition, the digital twin execution unit 40 is capable of virtually representing a situation in which the environment has changed by dynamically changing weather information, traffic congestion information, and the like.

Further, for example, the digital twin execution unit 40 reproduces an object such as roads and buildings in the digital twin based on map data of roads, buildings, and the like in the real world. Then, the digital twin execution unit 40 reproduces the operation status of each of multiple transportation systems in the digital twin based on, for example, the actual operation data of the transportation systems. In addition, the digital twin execution unit 40 reproduces the situation of accidents that have occurred on a road and the weather condition in the digital twin based on, for example, sensing data obtained from sensors deployed in the real world.

The generation processing unit 50 includes a movement purpose data generation unit 51, a destination data generation unit 52, an attribute generation unit 53, and a movement data generation unit 54, and the generation processing unit 50 is a processing unit that generates movement data, which is information used to simulate the movement of a person in a digital twin and to evaluate a measure.

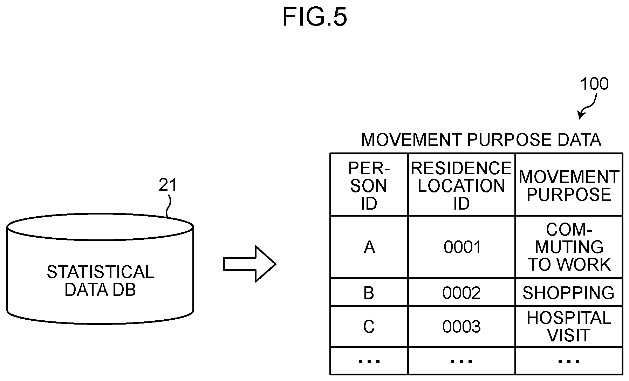

The movement purpose data generation unit 51 is a processing unit that generates movement purpose data 100, which indicates the movement purpose of a person. FIG. 5 is a diagram illustrated to describe an example of generating the movement purpose data. As illustrated in FIG. 5, the movement purpose data generation unit 51 extracts a residence location and a movement purpose of each person from the statistical data stored in the statistical data DB 21.

For example, the movement purpose data generation unit 51 generates the movement purpose data 100 in which a "person ID" that identifies a person, a "residence location ID" that identifies the residence location of a person, and a "movement purpose" that indicates the movement purpose of the person are associated with each other. In the example of FIG. 5, it is illustrated that a person with "person ID = A" resides in a region identified by "residence location ID = 0001" and has moved from the region with a "movement purpose" of "commuting to work". It is also illustrated that a person with "person ID = B" resides in a region identified by "residence location ID = 0002" and has moved from the region with a "movement purpose" of "shopping".

The destination data generation unit 52 is a processing unit that generates destination data related to a destination to which a person has moved, and merges the generated destination data with the movement purpose data 100. Specifically, in the case where the movement purpose of a person is commuting to work or attending school, the destination data generation unit 52 generates the destination data based on the selection probability calculated from statistical data. On the other hand, in the case where the movement purpose of a person is other than commuting to work or attending school, the destination data generation unit 52 generates the destination data based on the selection probability calculated from the attribute information of the person.

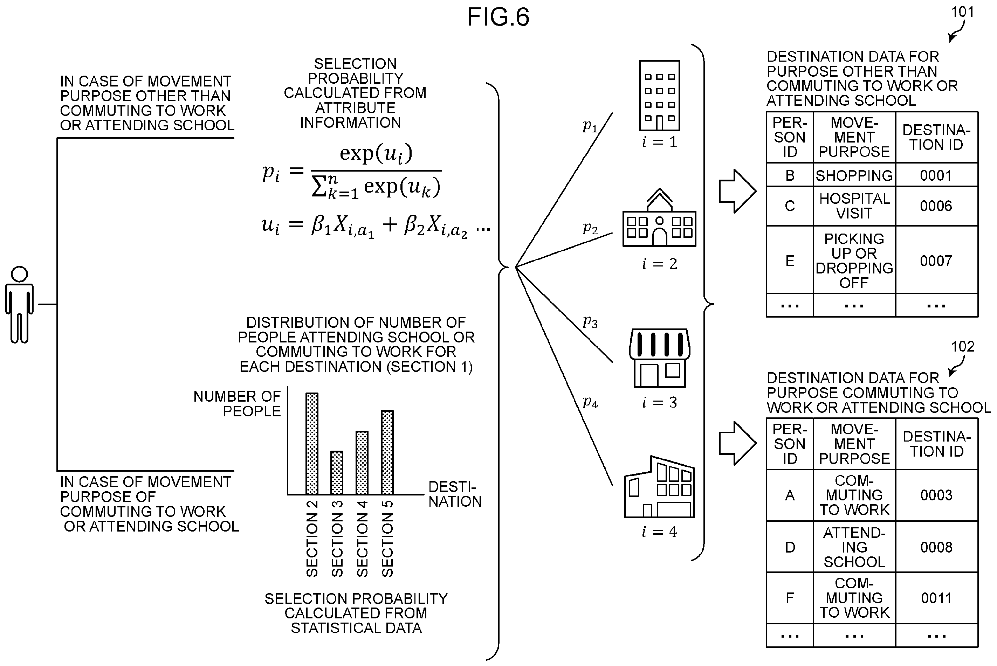

FIG. 6 is a diagram illustrated to describe an example of generating the destination data. As illustrated in FIG. 6, the destination data generation unit 52 extracts the movement purpose of each person from the statistical data stored in the statistical data DB 21. Then, the destination data generation unit 52 generates the destination data for a person having a movement purpose of other than commuting to work or attending school, such as shopping, hospital visits, and picking up or dropping off, using the selection probability described in FIG. 2. For example, the destination data generation unit 52 generates, as destination data 101 other than commuting to work or attending school, the destination data 101 in which a "person ID" that identifies a person, a "movement purpose" that identifies the movement purpose of the person, and a "destination ID" that identifies the destination to which the person has moved are associated. In the example of FIG. 6, it is illustrated that a person with "person ID = B" has moved to "destination ID = 0001" for "movement purpose = shopping", and a person with "person ID = C" has moved to "destination ID = 0002" for "movement purpose = hospital visit".

On the other hand, for a person with the movement purpose of commuting to work or attending school, the destination data generation unit 52 determines the destination depending on the distribution of the number of people commuting to work and attending school for each destination in the residence location of the person. For example, for a person in section 1, the destination data generation unit 52 can select, as a destination, section 2 with the highest number of people distribution, select the destination closest to the random variable as in FIG. 2, or select the destination having the highest number of people with the same attribute by aggregating the number of people distribution by an attribute of a person (such as gender). For example, the destination data generation unit 52 generates destination data 102 that associates "person ID", "movement purpose", and "destination ID" as the destination data 102 for commuting to work and attending school. The example in FIG. 6 illustrates that a person with "person ID = A" has moved to "destination ID = 0003" with "movement purpose = commuting to work".

Subsequently, the destination data generation unit 52, upon generating the destination data 101 other than commuting to work and attending school and the destination data 102 for commuting or attending school, merges these pieces of data with the movement purpose data 100 to generate destination data 103 for "residence location, movement purpose, destination".

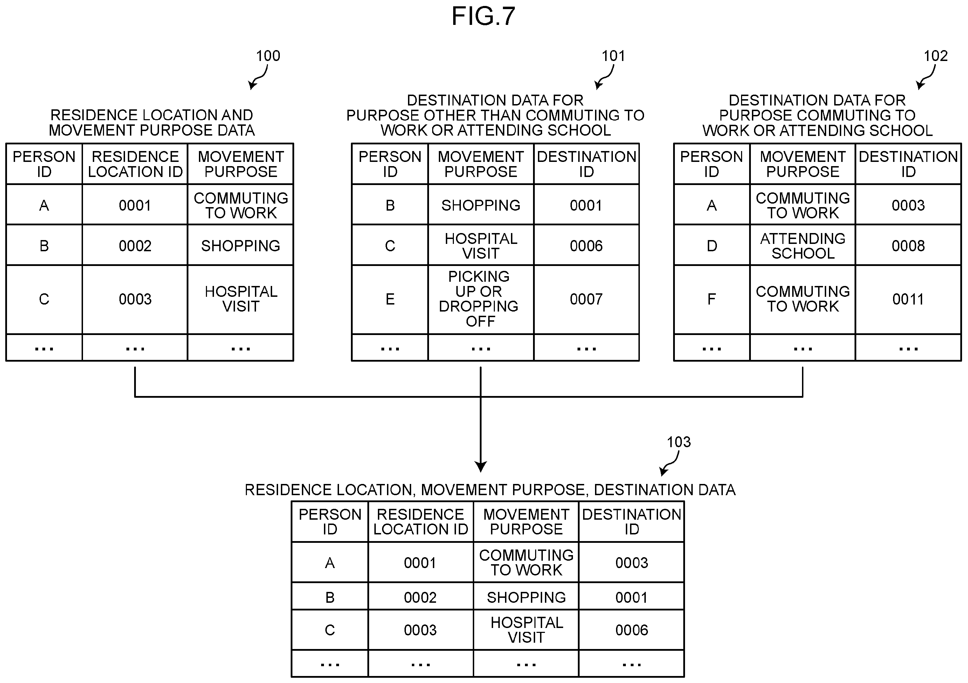

FIG. 7 is a diagram illustrated to describe an example of adding the destination data. As illustrated in FIG. 7, the destination data generation unit 52 merges the movement purpose data 100 of "person ID, residence location ID, movement purpose", the destination data 101 with purposes other than commuting to work or attending school, which includes "person ID, movement purpose, destination ID", and the destination data 102 for commuting to work or attending school, which includes "person ID, movement purpose, destination ID", and then generates destination data 103, which includes "residence location, movement purpose, destination".

For example, the destination data generation unit 52 collects data associated with "person ID = A" from each piece of the movement purpose data 100, the destination data 101 for purposes other than commuting to work or attending school, and the destination data 102 for commuting to work or attending school, and generates "person ID = A, residence location ID = 0001, movement purpose = commuting to work, destination ID = 0003". Similarly, the destination data generation unit 52 collects data associated with "person ID = B" and generates "person ID = B, residence location ID = 0002, movement purpose = shopping, destination ID = 0001".

The attribute generation unit 53 is a processing unit that generates an attribute other than the destination. Specifically, in the case where an attribute such as gender, age, income, and mode of transportation is included in the statistical data, the attribute generation unit 53 uses the attribute, whereas in the case where the attribute is not included in the statistical data, the attribute generation unit 53 generates an attribute using the model described in FIG. 2.

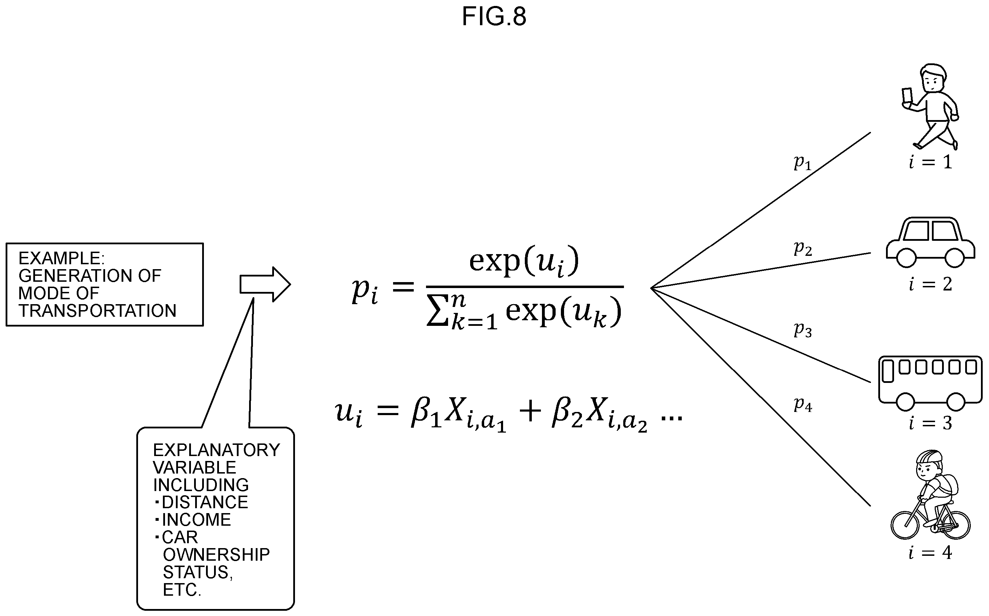

FIG. 8 is a diagram illustrated to describe an example of generating the attribute. For an attribute not included in the statistical data, the attribute generation unit 53 generates the attribute in a manner similar to that of FIG. 2, as illustrated in FIG. 8. For example, in the case of the attribute "mode of transportation", as illustrated in FIG. 8, the attribute generation unit 53 calculates the utility "u" of the mode of transportation using "distance, income, car ownership status" as the explanatory variable, and calculates the selection probability "pᵢ" of each mode of transportation using the utility "u". Then, the attribute generation unit 53 selects the "pᵢ" with the highest selection probability, the "pᵢ" closest to a random variable, or the like as the mode of transportation. Moreover, examples of the mode of transportation include walking for "i = 1", taking an automobile for "i = 2", taking a bus for "i = 3", riding a bicycle for "i = 4", or the like.

Further, it is preferable to use information that affects or relates to the calculation target (mode of transportation in FIG. 8) as the explanatory variable. In the example of FIG. 8, the mode of transportation is often changed depending on factors such as the car ownership and the distance, so such factors are used as the explanatory variable for the calculation. Moreover, since it is also considerable that a person commutes to work after picking up or dropping off at a daycare or kindergarten, the use of family composition or the like as the explanatory variable is useful.

The movement data generation unit 54 is a processing unit that generates movement data used for simulating the movement of a person using a digital twin. Specifically, the movement data generation unit 54 generates attribute-added movement data 104 in which the attribute generated by the attribute generation unit 53 is combined with the "residence location, movement purpose, destination" data 103 generated by the destination data generation unit 52.

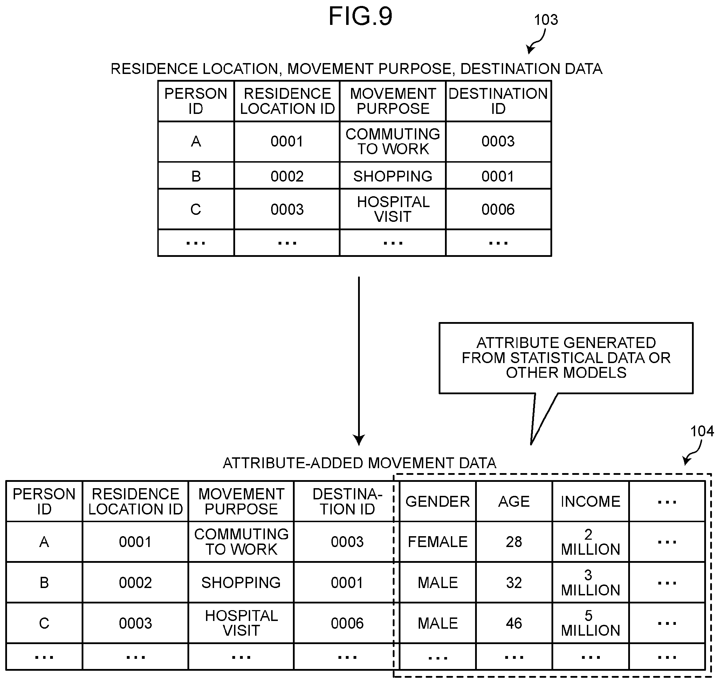

FIG. 9 is a diagram illustrated to describe an example of generating the attribute-added movement data 104. As illustrated in FIG. 9, the movement data generation unit 54 generates the attribute-added movement data in which the attribute "gender = female, age = 28, income = 2 million, ..." generated for a person with "person ID = A" is added to "person ID = A, residence location ID = 0001, movement purpose = commuting to work, destination ID = 0003" of the "residence location, movement purpose, destination" data 103.

The measure processing unit 60 includes a measure implementation unit 61, a measure analysis unit 62, and a visualization unit 63, and is a processing unit that uses the attribute-added movement data generated by the generation processing unit 50 to execute a simulation concerning the movement of a person on the digital twin upon conducting a measure and verify the measure.

The measure implementation unit 61 is a processing unit that executes a simulation concerning the movement of a person on the digital twin in the case where a measure is conducted in a predetermined area within a specific region. Specifically, the measure implementation unit 61 uses the attribute-added movement data 104 to execute a simulation in which an agent corresponding to each of multiple people included in the attribute-added movement data 104 moves on the digital twin.

For example, as one example of a measure to alleviate traffic congestion, a case is described in which an area with high traffic volume or a high number of traffic accidents, which is an example of a predetermined area in a specific region A, is established as a toll area. To begin with, the measure implementation unit 61 executes a movement simulation of before measure implementation. Specifically, the measure implementation unit 61 generates the region A on the digital twin, performs positioning of each person who resides in the region A among the people included in the attribute-added movement data 104, and reproduces a virtual region A that is the same as the real-world environment.

In this circumstance, the measure implementation unit 61 uses the digital twin to generate an agent corresponding to each person using the attribute-added movement data 104 of the person positioned in the virtual region A, and identifies the movement trajectory of each person before the measure implementation by performing a simulation of movement of each agent.

Subsequently, the measure implementation unit 61 establishes a toll area in the region A on the digital twin. Then, the measure implementation unit 61 generates an agent corresponding to each person using the attribute-added movement data 104 of the person positioned in the virtual region A where the toll area is established, and identifies the movement trajectory of each person after the measure implementation by performing the simulation for the movement of each agent.

In this regard, the measure implementation unit 61 is also capable of executing time synchronization between the real-world environment and the virtual environment (digital twin) and executing a simulation in the same time period as the real-world environment. Furthermore, the measure implementation unit 61 is capable of setting any conditions to be verified, such as weather information like rain or snow, information regarding event dates like New Year's Day or concert date, and traffic information like road closure and one-way streets, in the digital twin, allowing multiple realistic simulations corresponding to various anticipated situations to be executed.

The measure analysis unit 62 is a processing unit that generates a verification result obtained by verifying a measure to be applied to a predetermined area regarding the movement of a person, based on the result of the simulation performed by the measure implementation unit 61. Specifically, the measure analysis unit 62 analyzes the movement trajectory before and after the measure implementation, which is the result of the simulation, and identifies the situation of the predetermined area and the congestion status of the predetermined area based on a result obtained by the analysis.

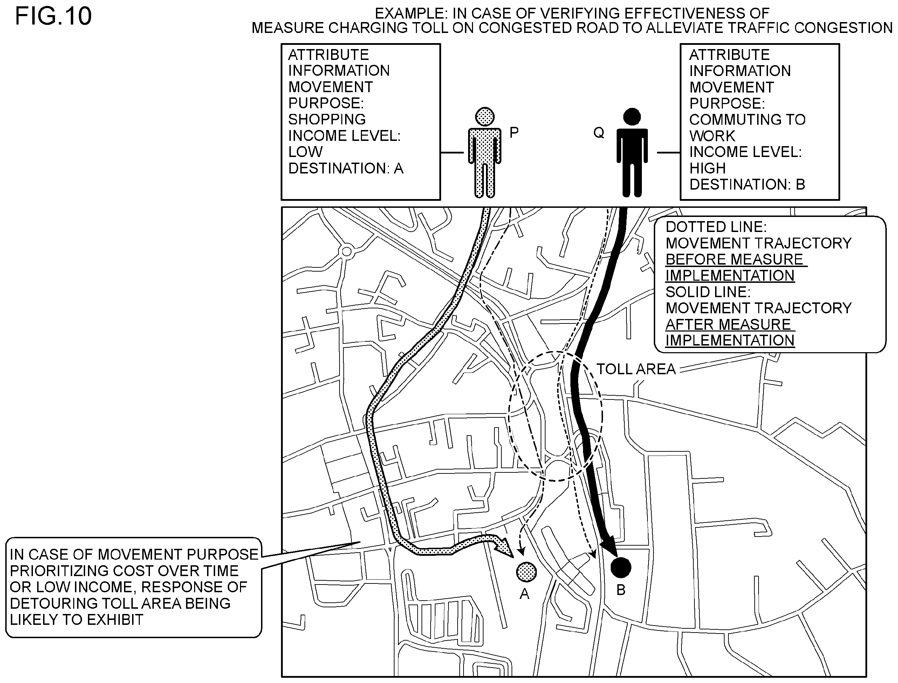

FIG. 10 is a diagram illustrated to describe an example of measure analysis. As illustrated in FIG. 10, the measure analysis unit 62 identifies a change in the movement trajectory of a person P with attribute information "movement purpose: shopping, income level: low, destination: A" and a change in the movement trajectory of a person Q with attribute information "movement purpose: commuting to work, income level: high, destination: B" with respect to the movement routes to destinations A and B in the same region before and after the establishment of the toll area.

For example, the measure analysis unit 62 displays the toll area on the digital twin, displays the movement routes of the person P and person Q before the measure obtained by the measure implementation unit 61 with the dotted line, and displays the movement routes of the person P and person Q after the measure implementation obtained by the measure implementation unit 61 with the solid line. Then, the measure analysis unit 62 identifies that the movement trajectory of person P has changed to a trajectory that does not pass through the toll area, and that there is no change in the movement trajectory of person Q.

Then, the measure analysis unit 62 analyzes the effectiveness of the measure based on the change in the trajectory and the attribute information. In this example, the measure analysis unit 62 analyzes that since the movement purposes or incomes of person P and person Q are different, if the movement purpose is shopping in which cost is prioritized over time, or if the person has a low income, a response of detouring the toll area is likely to exhibit.

Moreover, in FIG. 10, an analysis example illustrating the movement trajectories of two persons is described, but this is merely an example. For example, the measure analysis unit 62 is also capable of analyzing a change in the number of vehicles in a toll area and a change in the number of congested roads.

As described above, the measure analysis unit 62 generates, as the verification result, the change in the movement trajectories of a person before and after the measure implementation, the change in the number of vehicles in the toll area, the change in the number of congested roads, and the like, and outputs the result to the visualization unit 63. Moreover, the measure analysis unit 62 is also capable of storing a change in data during the simulation (e.g., change in movement trajectories and change in the number of vehicles) and outputting the stored data to the visualization unit 63.

The visualization unit 63 is a processing unit that visualizes the verification result generated by the measure analysis unit 62. Specifically, the visualization unit 63 generates a display screen that presents the verification result such as the change in the movement trajectory of the person before and after the measure implementation, the change in the number of vehicles in the toll area, the change in the number of congested roads, and the like, and outputs the generated display screen to the display unit 12 or transmits it to an administrator terminal.

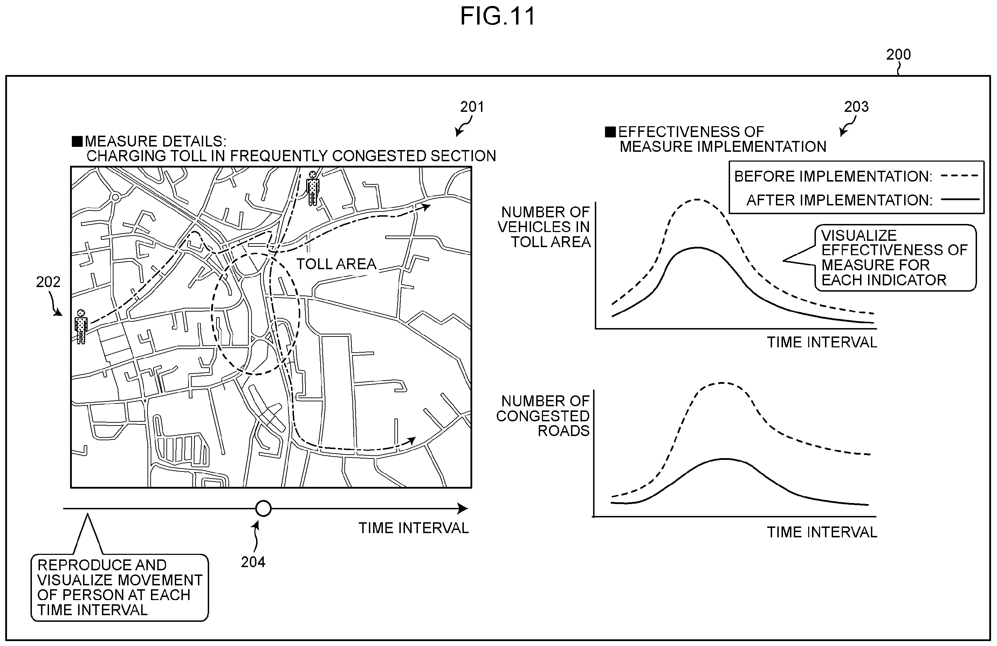

FIG. 11 is a diagram illustrated to describe an example of displaying the effectiveness of a measure. As illustrated in FIG. 11, the visualization unit 63 generates a display screen 200 including a zone 201 indicating the measure details, a zone 202 indicating the simulation information of the measure target, and an effectiveness 203 of measure implementation. In the example of FIG. 11, the visualization unit 63 displays the measure details of "charging a toll in a frequently congested section" in the zone 201. In addition, the visualization unit 63 displays the target region of the simulation and the result of the simulation in the zone 202, and displays the time series change in the simulation in response to the operation of a button 204. Furthermore, the visualization unit 63 displays, in the effectiveness 203 of measure implementation, a graph representing the time series change in the number of vehicles in the toll area before and after the measure implementation and a graph representing the time series change in the number of congested roads before and after the measure implementation.

### Processing Procedure

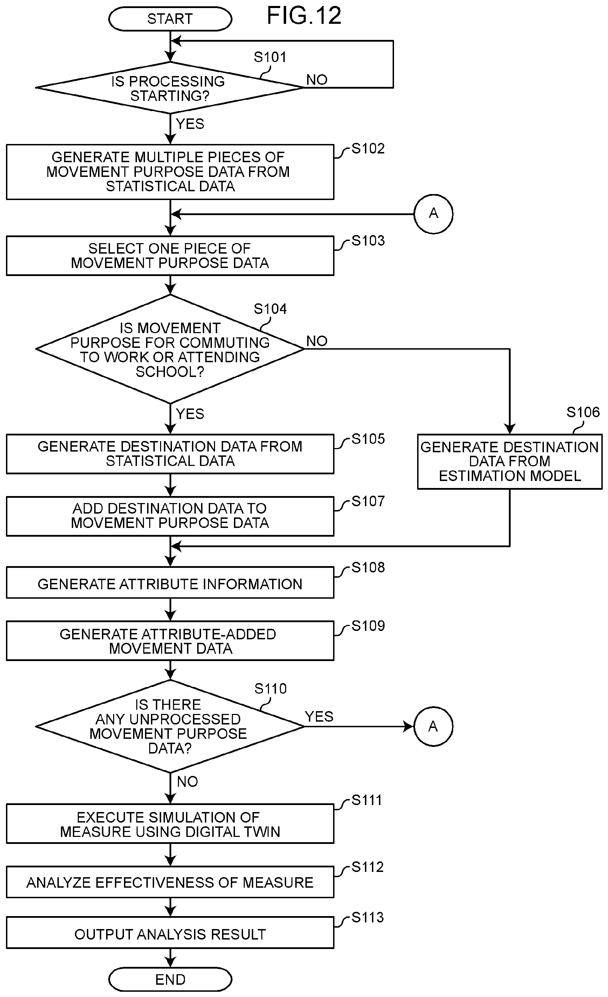

FIG. 12 is a flowchart illustrating the processing procedure. As illustrated in FIG. 12, if the information processing device 10 receives an instruction to start processing from an administrator or the like (S101: Yes), the information processing device 10 generates multiple pieces of movement purpose data from statistical data (S102).

Subsequently, the information processing device 10 selects one piece of movement purpose data (S103) and determines whether or not the movement purpose corresponds to commuting to work or attending school (S104). In this step, if the movement purpose corresponds to commuting to work or attending school (S104: Yes), the information processing device 10 generates destination data from statistical data (S105). On the other hand, if the movement purpose is neither commuting to work nor attending school (S104: No), the information processing device 10 generates destination data from an estimation model (S106).

Subsequently, the information processing device 10 adds (combines) the destination data to the movement purpose data (S107), generates and further adds attribute information (S108), and generates attribute-added movement data (S109).

In this step, if there are any remaining unprocessed movement purpose data (S110: Yes), the information processing device 10 repeats the processing from S103 onward. On the other hand, if there is no remaining unprocessed movement purpose data (S110: No), the information processing device 10 executes a simulation of the measure in the digital twin (S111), analyzes the effectiveness of the measure (S112), and outputs a result obtained by the analysis (S113).

### Effects

As described above, the information processing device 10 is capable of executing the measure verification using the digital twin, so it is possible to verify the measure by constructing an assumed environment, rather than being limited to the real-world environment, improving the accuracy of the measure verification.

In addition, the information processing device 10 is capable of generating destination data for commuting to work and attending school as well as destination data for other purposes using techniques suitable for each type of destination data, so it is possible to generate destination data and attribute-added movement data with high accuracy that does not deviate from the statistical data.

Further, the information processing device 10 is capable of generating an attribute that is not included in the statistical data and combining the attribute with the destination data, so it is possible to generate the attribute-added movement data with high accuracy that does not deviate from the statistical data.

Additionally, the information processing device 10 uses highly accurate destination data and attribute-added movement data to execute a simulation regarding the movement of a person, so it is possible to improve the accuracy of the simulation. Furthermore, the information processing device 10 is capable of verifying a measure using a high-accuracy simulation, so it is possible to improve the accuracy of the measure verification.

### (b) Second Embodiment

Although the embodiment of the present invention has been described, the present invention is not limited to the aforementioned embodiment and can be implemented in various other modes.

### Numerical Value and Other Factors

The attribute names, models, numerical values, graphs, and the like used in the above-described embodiment are merely examples and can be modified as desired. In addition, the procedure of the processing described in each flowchart can also be modified as appropriate as long as there is no inconsistency.

### Simulation using Behavior Selection Model

The information processing device 10 is capable of executing a simulation and displaying a verification result by employing a behavior selection model used to determine whether a person acts in accordance with a measure.

For example, the controller 30 of the information processing device 10 acquires a behavior selection model used to determine whether a person acts in accordance with a measure. Subsequently, the controller 30 of the information processing device 10 executes a simulation in the digital twin to determine whether an agent complies with a first measure, for example, using the attribute information of a person and the behavior selection model. Then, the controller 30 of the information processing device 10 performs a simulation regarding the movement of the person, for example, using an execution result of the simulation that is used to determine whether the agent complies. After that, the controller 30 of the information processing device 10 generates information indicating the verification result of the measure to be applied to a predetermined area, for example, based on a result of the performed simulation.

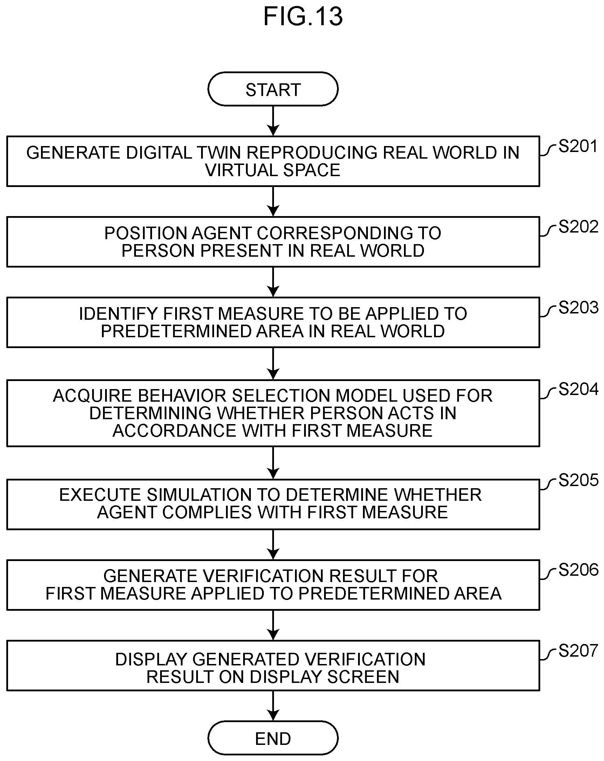

FIG. 13 is a flowchart illustrating the procedure of a simulation using a behavior selection model. The information processing device 10 first generates a digital twin that reproduces the real world in a virtual space (step S201). Next, the information processing device 10 performs the positioning of an agent, which corresponds to a person present in the real world, in the digital twin (step S202).

The information processing device 10 identifies a first measure to be applied to a predetermined area in the real world (step S203). The information processing device 10 acquires a behavior selection model used to determine whether a person acts in accordance with the first measure (step S204). Subsequently, the information processing device 10 executes a simulation in the digital twin to determine whether the agent complies with the first measure, using attribute information of the person corresponding to the agent and the behavior selection model (step S205). The information processing device 10 performs, using the result of the executed simulation, a simulation regarding the movement of the person to generate a verification result obtained by verifying the first measure applied to the predetermined area (step S206). The information processing device 10 displays the generated verification result on the display screen (step S207).

More specifically, the information processing device 10 acquires terminal data that is obtaines through a terminal from the terminal used by a person present in a predetermined area of the real world through communication. Subsequently, the information processing device 10 performs the positioning of an agent corresponding to the person on the digital twin in which the virtual space and the real world are time-synchronized, based on the acquired terminal data. Then, the information processing device 10 associates the positioned agent with the attribute-added movement data of the person. In this case, the information processing device 10 identifies the attribute information of the agent by associating the positioned agent with the attribute information of the person.

Further, the information processing device 10 acquires a behavior selection model, which is a machine learning model used for determining whether a person acts in accordance with a measure. Next, the information processing device 10 executes a simulation of determining whether the agent complies with the first measure by inputting attribute information of the agent present in the digital twin into the behavior selection model. Subsequently, the information processing device 10 identifies the condition of the predetermined area based on the result of the executed simulation.

Moreover, the information processing device 10 identifies the first measure to be applied to the predetermined area in the real world. The information processing device 10 receives the measure from, for example, a terminal of an administrator. Subsequently, the information processing device 10 identifies a behavior selection model for the measure to be applied to the predetermined area in the real world. In this case, the information processing device 10 identifies a behavior selection model for the first measure to be applied to the predetermined area in the real world.

More specifically, the information processing device 10 determines whether each of the multiple agents complies with the first measure by inputting the attribute information of the agent present in the digital twin into the acquired behavior selection model. Subsequently, the information processing device 10 executes a simulation of whether each of the multiple agents moves within a predetermined area, based on a result obtained by the determination. Then, the information processing device 10 identifies the degree of congestion in the predetermined area based on the execution result of the simulation of whether to move within the predetermined area.

For example, the information processing device 10 inputs person's movement data with attribute information of an agent corresponding to a first person into the machine learning model. In this case, for example, the information processing device 10 determines that the agent corresponding to the first person acts in accordance with the first measure based on the output result of the machine learning model, and does not move the agent from the predetermined area. Meanwhile, the information processing device 10 inputs person's movement data with attribute information of an agent corresponding to a second person into the machine learning model. In this case, the information processing device 10 determines that the agent corresponding to the second person does not act in accordance with the first measure based on the output result of the machine learning model, and moves the agent from the predetermined area. Then, the information processing device 10 identifies the degree of congestion in the predetermined area based on the movement result of each of the multiple agents. After that, the information processing device 10 generates a verification result of the measure applied to the predetermined area using the identified degree of congestion.

Moreover, in introducing an infallible measure, such as a social measure or policy, into the real world, prior verification of the measure is desirable. In this case, the information processing device 10 is capable of improving the accuracy of the measure verification. In addition, the use of a simulation employing a behavior selection model makes it possible to reduce the load of computer processing in performing the simulation.

Moreover, the behavior selection model is trained as a machine learning model based on the correct answer label of information regarding whether a person acts in accordance with the first measure, and training data including attribute information of the person. For example, the information processing device 10 updates a parameter of the neural network in the machine learning model, based on the output result of the machine learning model upon inputting the movement data of a person with attribute information of the person into the machine learning model and the correct answer label indicating information regarding whether the person acts in accordance with the first measure in a predetermined area. This configuration enables the information processing device 10 to generate a machine learning model that determines whether the person acts in accordance with the measure.

### Destination Data

In the above-described embodiment, the example is described in which the information processing device 10 executes a simulation using attribute-added movement data, but this configuration is not limited to this example. For example, the information processing device 10 is also capable of executing a simulation using solely destination data. In this case, since the amount of information is small, the information processing device 10 is capable of executing a high-speed simulation that is narrowed down to the movement trajectory from the departure point to the destination, which results in a reduction in the time taken for the verification while maintaining the accuracy of the verification of the measure.

Further, in the case of generating the destination data, the information processing device 10 is capable of generating the destination data using a pre-trained model. For example, the information processing device 10 prepares an estimation model, which inputs an attribute of a person known from statistical data such as gender or residence location and outputs a destination, for each of different movement purposes, such as an estimation model for commuting to work and attending school, an estimation model for shopping, and an estimation model for hospital visit. Then, the information processing device 10 is capable of generating a destination using an estimation model corresponding to the movement purpose and accordingly generating destination data using the generated destination.

### Simulation

In the above-described embodiment, the example is described in which the information processing device 10 executes a simulation regarding the movement of a person, but this configuration is not limited to the above-described example. For example, the information processing device 10 is capable of executing a traffic simulation regarding road traffic such as automobiles, buses, and taxis. Moreover, it is possible for each simulation to employ various commonly used calculation formulas and simulation techniques.

### System

The processing procedures, control procedures, specific names, and information including various types of data and parameters presented herein and drawings can be optionally modified unless otherwise specified.

Further, the specific implementation of distributing and integrating the components of each device or apparatus is not limited to the illustrated examples. For example, the digital twin execution unit 40, the generation processing unit 50, and the measure processing unit 60 can be integrated. In other words, the entirety or a part of the components can be functionally or physically distributed or integrated into any subsystems or modules depending on various factors such as load and usage status. Furthermore, each processing function of each device or component can be implemented in whole or in part by a CPU and a program analyzed and executed by the CPU, or alternatively, by hardware using wired logic.

Furthermore, each processing function performed by each device or component can be implemented in whole or in part by a CPU and a program analyzed and executed by the CPU, or alternatively, by hardware using wired logic.

### Hardware

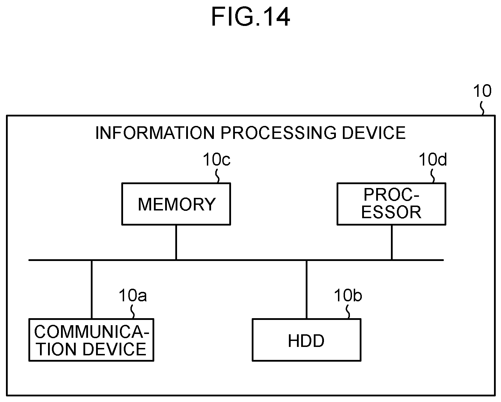

FIG. 14 is a diagram illustrated to describe an exemplary hardware configuration. As illustrated in FIG. 14, the information processing device 10 includes a communication device 10a, a hard disk drive (HDD) 10b, a memory 10c, and a processor 10d. Additionally, the respective components illustrated in FIG. 14 are connected to each other via a bus or similar connection.

The communication device 10a is a network interface card or the like, and allows communication with other devices. The HDD 10b stores programs and DBs for operating the functions illustrated in FIG. 4.

The processor 10d reads a program for executing processing similar to that of each processing unit illustrated in FIG. 4 from the HDD 10b or the like and loads the read program into the memory 10c, thereby operating a process for executing each function described in FIG. 4 and the like. For example, this process executes a function similar to that of each processing unit included in the information processing device 10. Specifically, the processor 10d reads a program having a function similar to that performed by the digital twin execution unit 40, the generation processing unit 50, the measure processing unit 60, or the like from the HDD 10b or the like. Then, the processor 10d executes a process that performs processing similar to that performed by the digital twin execution unit 40, the generation processing unit 50, the measure processing unit 60, or the like.

In this way, the information processing device 10 operates as an information processing device that executes a method of verifying and estimating the measure by reading and executing the program. In addition, the information processing device 10 is also capable of implementing a function similar to that of the above-described embodiment by reading the above-mentioned program from a recording medium using a medium reading device and executing the read program. Moreover, the program in other embodiments is not limited to being executed by the information processing device 10. For example, the above-described embodiment can be similarly applied to a case where another computer or server executes the program or a case where these cooperate to execute the program.

Such a program can be distributed over a network such as the Internet. In addition, the program can be recorded on a computer-readable recording medium such as a hard disk, a flexible disk (FD), a CD-ROM, a magneto-optical disk (MO), or a digital versatile disc (DVD), and can be executed by being read from the recording medium by a computer.

According to one embodiment, it is possible to improve the accuracy of measure verification.

## Claims

1. A measure execution program that causes a computer (10) to execute a process comprising:
generating (S201) a digital twin reproducing a real world in a virtual space;
acquiring (S202, S203) information regarding a person present in a predetermined area of the real world;
performing (S204, S205), in the generated digital twin, a simulation concerning movement of the person using the acquired information regarding the person;
generating (S206) information indicating a verification result of a measure to be applied to the predetermined area based on a result of the performed simulation; and
outputting (S207) the generated information indicating the verification result to a display screen.

2. The measure execution program according to claim 1, wherein
the performing (S204, S205) includes executing, using the digital twin, a traffic simulation employing destination data regarding a destination for the movement of the person, and
the generating (S206) includes generating the information indicating the verification result of the measure to be applied to the predetermined area regarding the movement of the person based on a result of the traffic simulation.

3. The measure execution program according to claim 1 or 2, wherein
the process further includes generating (S105) the destination data for the movement of the person using attribute information of the person, wherein
the performing (S204, S205) includes executing, using the digital twin, the simulation concerning the movement of the person employing the destination data regarding the destination for the movement of the person, and
the generating (S206) includes generating the information indicating the verification result of the measure to be applied to the predetermined area regarding the movement of the person based on a result of the simulation.

4. The measure execution program according to claim 3, wherein
the process further includes:
acquiring a movement purpose of the person; and
identifying, using the movement purpose of the person, a model associated with the movement purpose of the person from among a plurality of models,
wherein the generating (S206) includes generating the destination data using the identified model.

5. The measure execution program according to claim 3, wherein
the destination data is generated based on a selection probability calculated from statistical data in a case where a movement purpose of the person is commuting to work or attending school, and
the destination data is generated based on a selection probability calculated from the attribute information of the person in a case where the movement purpose of the person is other than commuting to work and attending school.

6. The measure execution program according to claim 5, wherein
the process further includes
generating (S109) first combined data and second combined data, the first combined data being obtained by combining the destination data generated from the statistical data with the attribute information of the person, the second combined data being obtained by combining the attribute information of the person with the destination data generated from the attribute information of the person,
wherein the performing (S204, S205) includes executing, using the digital twin, the simulation concerning the movement of the person using the first combined data and the second combined data.

7. The measure execution program according to claim 1, wherein
the acquiring (S202, S203) includes
acquiring the destination data with a destination associated with each of the persons,
the performing includes
performing, using the acquired destination data, a simulation of moving an agent corresponding to each of a plurality of persons on the digital twin, and
the generating includes
identifying a condition of the predetermined area based on a result of the simulation.

8. The measure execution program according to claim 7, wherein
the measure to be applied to the predetermined area is a measure for alleviating traffic congestion,
the generating (S206) includes
identifying congestion status of the predetermined area based on the result of the simulation, and
generating the information indicating the verification result of the measure to be applied to the predetermined area using the identified congestion status.

9. The measure execution program according to claim 1, wherein
the performing (S204, S205) includes:
acquiring a behavior selection model for determining whether the person acts in accordance with the measure;
executing a simulation of determining whether an agent complies with a first measure in the digital twin using the acquired behavior selection model and the acquired information regarding the person; and
performing a simulation concerning the movement of the person using an execution result of the simulation of determining whether the agent complies.

10. The measure execution program according to claim 9, wherein
the information regarding the person is the attribute information of the person,
the performing (S204, S205) includes
executing a simulation of determining whether each of a plurality of agents moves within the predetermined area by determining whether each agent complies with the first measure based on the attribute information of the agent present in the digital twin and the acquired behavior selection model,
identifying congestion status of the predetermined area based on the result of the simulation for determining whether to move within the predetermined area, and
generating information indicating a verification result of the first measure to be applied to the predetermined area using the identified congestion status.

11. The measure execution program according to claim 10, wherein
the generating (S206) includes:
acquiring terminal data, via communication, from a terminal used by the person present in the predetermined area of the real world;
positioning an agent corresponding to the person on a digital twin in which the virtual space and the real world are time-synchronized, based on the acquired terminal data; and
associating the attribute information of the person with the agent positioned on the digital twin,
the performing (S204, S205) includes:
receiving a first measure to be applied to the predetermined area;
acquiring a behavior selection model for the first measure, the behavior selection model being a machine learning model for determining whether the person acts in accordance with the measure; and
executing a simulation to determine whether the agent complies with the first measure in the digital twin, based on the acquired behavior selection model for the first measure and the attribute information of the person.

12. A measure execution method carried out by a computer (10), comprising:
generating (S201) a digital twin reproducing a real world in a virtual space;
acquiring (S202, S203) information regarding a person present in a predetermined area of the real world;
performing (S204, S205), in the generated digital twin, a simulation concerning movement of the person using the acquired information regarding the person;
generating (S206) information indicating a verification result of a measure to be applied to the predetermined area based on a result of the performed simulation; and
outputting (S207) the generated information indicating the verification result to a display screen.

13. An information processing device that includes a control unit (30) configured to execute a process comprising:
generating a digital twin reproducing a real world in a virtual space;
acquiring information regarding a person present in a predetermined area of the real world;
performing, in the generated digital twin, a simulation concerning movement of the person using the acquired information regarding the person;
generating information indicating a verification result of a measure to be applied to the predetermined area based on a result of the performed simulation; and
outputting the generated information indicating the verification result to a display screen.
